# EUROPEAN PATENT SPECIFICATION

(11) **EP 4 064 572 B1**
(45) Date of publication and mention of the grant of the patent: **23.04.2025**
(21) Application number: 20908821.0
(22) Date of filing: 30.09.2020
(51) Int. Cl.: H03M 9/00, G06F 13/40, H04L 25/49

(54) **DATA PROCESSING METHOD AND APPARATUS**
DATENVERARBEITUNGSVERFAHREN UND -APPARAT
PROCÉDÉ ET APPAREIL DE TRAITEMENT DE DONNÉES

(30) Priority: 31.12.2019 CN 201911417101
(43) Date of publication of application: 28.09.2022
(73) Proprietor: HUAWEI TECHNOLOGIES CO., LTD., Shenzhen, Guangdong 518129 (CN)
(72) Inventor: LI, Zan, Shenzhen, Guangdong 518129 (CN); LIU, Zhaowei, Shenzhen, Guangdong 518129 (CN)
(74) Representative: Gill Jennings & Every LLP
(86) International application number: PCT/CN2020/119151
(87) International publication number: WO 2021/135478

(56) References cited:
- CN-A- 1 543 224
- CN-A- 104 982 018
- CN-A- 107 040 430
- CN-A- 108 933 600
- US-A1- 2009 031 185
- US-A1- 2009 168 862
- US-A1- 2014 146 833

## Description

This application claims priority to Chinese Patent Application No. 201911417101.8, filed with the China National Intellectual Property Administration on December 31, 2019 and entitled "DATA PROCESSING METHOD AND APPARATUS".

### TECHNICAL FIELD

This application relates to the field of data processing, and in particular, to a data processing method and apparatus.

### BACKGROUND

In a communications technology, data may be transferred between interfaces. Specifically, the interface may be, for example, a serializer/deserializer (serializer/deserializer, SerDes)-based interface.

To improve SerDes performance and to further improve data transmission performance, a training frame (training frame) may be transferred between interfaces, and the interfaces may further adjust a related parameter of a SerDes based on the training frame.

However, currently, an effect of optimizing SerDes performance by transferring a training frame between interfaces is not good.
US-A-2009/0168862 describes methods for detecting and decoding adaptive equalization training frames (having a frame marker comprised of a string of binary ones and binary zeroes). Training frames are detected by shifting the received data; inserting at least one binary value at one end of the shifted received data to generate a modified version of the received data; applying a logic function to the received data and the modified version of the received data that identifies when corresponding bit positions have different values; and detecting the frame marker when an output of the logic function has a first binary value in an approximate middle of a string of a second binary value. The training frames are decoded using a distance between the approximate center of the frame maker and a predefined binary value in an output of the logic function.

### SUMMARY

The invention is defined by the independent claims. Preferred embodiments are set forth in the dependent claims.

Embodiments of this application provide a data processing method and apparatus, to improve an effect of optimizing SerDes performance by transferring a training frame between interfaces.

According to a first aspect, an embodiment of this application provides a data processing method, and the method may be performed by, for example, a first interface. The method includes: The first interface obtains a first encoding sequence. The first encoding sequence may include a plurality of sign bits, and the first encoding sequence may be sent by a second interface to the first interface. After obtaining the first encoding sequence, the first interface may parse the first encoding sequence. A signal transferred between interfaces may be a voltage signal, and information is exchanged by using a specific value of the voltage signal, namely, a voltage value. The first encoding sequence may be an encoding sequence obtained after a voltage signal sent by the second interface is encoded. When a voltage value sent by the second interface to the first interface jumps, a bit error is likely to occur in an encoded value received by the first interface, and the bit error is tolerable. Therefore, in this embodiment of this application, the first interface can also correctly parse the first encoding sequence when a tolerable bit error occurs in the first encoding sequence. For a target sign bit in the first encoding sequence, if a value of the target sign bit is different from a preset value of the target sign bit, the first encoding sequence is parsed based on the fact that the value of the target sign bit is equal to the preset value of the target sign bit. The target sign bit is one or more sign bits in which a bit error is likely to occur. It can be learned that, according to the solution in this embodiment of this application, for the target sign bit in which a bit error is likely to occur, if a bit error occurs in the target sign bit, in other words, the value of the target sign bit is different from the preset value of the target sign bit, the first interface can also correctly parse the first encoding sequence. This improves efficiency of obtaining a training frame through parsing by the first interface, and correspondingly improves an effect of optimizing SerDes performance by transferring a training frame between interfaces.

In a possible implementation, parsing the first encoding sequence in this embodiment of this application may mean identifying whether the first encoding sequence is a frame marker encoding sequence of the training frame.

In a possible implementation, both a control field encoding sequence and a status field encoding sequence of the training frame use 2*i sign bits to indicate logical bit information. Therefore, parsing the first encoding sequence in this embodiment of this application may be: When the first encoding sequence includes the status field encoding sequence or the control field encoding sequence, the first interface encodes the first encoding sequence to obtain a second encoding sequence.

In a possible implementation, IEEE Std 802.3^{™}-2018 Clause 72 specifies that the training frame is encoded through NRZ code, and IEEE Std 802.3cd^{™}-2018 Clause 136 specifies that the training frame is encoded by through PAM4. Therefore, the first encoding sequence may be an NRZ encoding sequence, that is, an encoding sequence that is encoded through NRZ encoding, or may be a PAM4 encoding sequence, that is, an encoding sequence that is encoded through PAM4.

In a possible implementation, in the frame marker encoding sequence of the training frame specified in IEEE Std 802.3^{™}-2018 Clause 72 and IEEE Std 802.3cd^{™}-2018 Clause 136, voltage values corresponding to the first 16 sign bits are the same, voltage values corresponding to the last 16 sign bits are the same, and the voltage values corresponding to the first 16 sign bits are different from the voltage values corresponding to the last 16 sign bits. In this case, a bit error is likely to occur in the 16^{th} sign bit and the 17^{th} sign bit that are received by the first interface. In addition, the inventor finds, through research, that a bit error is also likely to occur in a sign bit that is close to the 16^{th} sign bit, for example, the 15^{th} sign bit and the 14^{th} sign bit. Correspondingly, a bit error is also likely to occur in a sign bit that is close to the 17^{th} sign bit, for example, the 18^{th} sign bit and the 19^{th} sign bit. Therefore, if the first encoding sequence obtained by the first interface is similar to the frame marker encoding sequence of the training frame, the target sign bit may include m+n sign bits, where both m and n are integers greater than or equal to 0. Specifically, when m+n is equal to 1, the target sign bit includes one sign bit. In this case, the target sign bit may include a first sign bit or a second sign bit, the first sign bit is adjacent to the second sign bit, and a preset value of the first sign bit is different from a preset value of the second sign bit. The first sign bit herein may be, for example, the 16^{th} sign bit above, and the second sign bit herein may be, for example, the 17^{th} sign bit above. When m+n is greater than 1, the target sign bit may include m+n consecutive sign bits, preset values of the first m sign bits in the m+n consecutive sign bits are the same, preset values of the last n sign bits in the m+n consecutive sign bits are the same, and the preset values of the first m sign bits are different from the preset values of the last n sign bits. In other words, the last sign bit in the first m consecutive sign bits may be the first sign bit, and the 1^{st} sign bit in the last n consecutive sign bits may be the second sign bit. In addition, the control field encoding sequence follows the frame marker encoding sequence of the training frame, and a value of the 1^{st} sign bit in the control field encoding sequence may also be different from a value of the last sign bit in the frame marker encoding sequence. Therefore, a bit error is also likely to occur in the last sign bit in the frame marker encoding sequence. The inventor finds, through research, that a bit error is also likely to occur in a sign bit that is close to the last sign bit in the frame marker encoding sequence, for example, the second-to-last sign bit and the third-to-last sign bit in the frame marker encoding sequence. In view of this, if the first encoding sequence is similar to the frame marker encoding sequence of the training frame, the target sign bit may include the last k sign bits in the first encoding sequence, where k is an integer greater than or equal to 1.

In a possible implementation, when the voltage value sent by the second interface jumps, sign bits in which a bit error occurs in the encoded value received by the first interface are symmetric. In other words, a quantity of sign bits in which a bit error is likely to occur before a level jump is the same as a quantity of sign bits in which a bit error is likely to occur after the level jump. Therefore, m and n may be the same.

In a possible implementation, both the control field encoding sequence and the status field encoding sequence of the training frame specified in IEEE Std 802.3^{™}-2018 Clause 72 and IEEE Std 802.3cd^{™}-2018 Clause 136 use eight sign bits to indicate logical bit information. If values of the first four sign bits are the same as values of the last four sign bits, a value of the logical bit information indicated by the eight sign bits is 0; or if values of the first four sign bits are different from values of the last four sign bits, a value of the logical bit information indicated by the eight sign bits is 1. The 2*i sign bits indicating the logical bit information are referred to as a first encoding sub-sequence. If the first encoding sub-sequence is the control field encoding sequence or the status field encoding sequence of the training frame, a value of i may be equal to 4. A value of the logical bit information indicated by the first encoding sub-sequence may be 0 or 1. Therefore, a voltage value corresponding to the i^{th} sign bit may be different from a voltage value corresponding to the (i+1)^{th} sign bit in the first encoding sub-sequence. In this case, a bit error may occur in both the i^{th} sign bit and the (i+1)^{th} sign bit in the first encoding sub-sequence. In addition, the control field encoding sequence of the training frame may include one or more first encoding sub-sequences, and values of logical bits indicated by two adjacent first encoding sub-sequences may be the same or may be different. In other words, a value of the last sign bit in a current first encoding sub-sequence may be different from a value of the 1^{st} sign bit in a next first encoding sub-sequence. In this case, a bit error may occur in both the 1^{st} sign bit and the last sign bit, namely, the (2*i)^{th} sign bit, in the first encoding sub-sequence. Therefore, the target sign bit may include any one or more of the 1^{st} sign bit in the first encoding sub-sequence, the i^{th} sign bit in the first encoding sub-sequence, the (i+1)^{th} sign bit in the first encoding sub-sequence, and the (2*i)^{th} sign bit in the first encoding sub-sequence.

In a possible implementation, a specific value of each sign bit in the first encoding sub-sequence is not specified in IEEE Std 802.3^{™}-2018 Clause 72 and IEEE Std 802.3cd^{™}-2018 Clause 136, but the value of each sign bit in the first encoding sub-sequence needs to comply with a rule that values of the first i sign bits are the same and values of the last i sign bits are the same. The first interface may determine a preset value of the 1^{st} sign bit and a preset value of the i^{th} sign bit based on a preset value of a sign bit between the 1^{st} sign bit and the i^{th} sign bit. In an embodiment, an actual value of the sign bit between the 1^{st} sign bit and the i^{th} sign bit may be determined as the preset value of the sign bit between the 1^{st} sign bit and the i^{th} sign bit. Correspondingly, a preset value of the (i+1)^{th} sign bit and a preset value of the (2*i)^{th} sign bit are determined based on a preset value of a sign bit between the (i+1)^{th} sign bit and the (2*i)^{th} sign bit. After the preset value of the target sign bit is determined, when the value of the target sign bit is different from the preset value, parsing is performed based on the fact that the value of the target sign bit is equal to the preset value.

In a possible implementation, if the first encoding sequence is a PAM4 encoding sequence, a value of each sign bit in the status field encoding sequence and the control field encoding sequence of the training frame may be only 0 or 3. In addition, if the first encoding sequence is the status field encoding sequence or the control field encoding sequence, it indicates that the first interface has successfully received the frame marker encoding sequence of the training frame from the second interface. In this case, to further improve an effect of optimizing SerDes performance by transferring the training frame between the first interface and the second interface, for the control field encoding sequence and the status field encoding sequence of the training frame, error tolerance may be further relaxed. Specifically, the target sign bit may further include a first sign bit sequence and a second sign bit sequence. The first sign bit sequence includes the 2^{nd} sign bit to the (i-1)^{th} sign bit in the first encoding sub-sequence, and the second sign bit sequence includes the (i+1)^{th} sign bit to the (2*i-1)^{th} sign bit in the first encoding sub-sequence. Herein, a value of i is an integer greater than or equal to 3. For example, the value of i may be 4.

In a possible implementation, it is considered that the preset value of the 1^{st} sign bit and the preset value of the i^{th} sign bit are determined based on a value of each sign bit in the first sign bit sequence, and the preset value of the (i+1)^{th} sign bit and the preset value of the (2*i)^{th} sign bit are determined based on a value of each sign bit in the second sign bit sequence. If a bit error occurs in a sign bit in the first sign bit sequence, an actual value of the sign bit in the first sign bit sequence cannot be determined as a preset value of the sign bit in the first sign bit sequence, and consequently the preset value of the 1^{st} sign bit and the preset value of the i^{th} sign bit cannot be determined. Correspondingly, if a bit error occurs in a sign bit in the second sign bit sequence, the preset value of the (i+1)^{th} sign bit and the preset value of the (2*i)^{th} sign bit cannot be determined. To resolve this problem, a preset value of each sign bit in the first sign bit sequence may be determined based on the value of each sign bit in the first sign bit sequence. For PAM4 encoding sequence, for a sign bit whose preset value is 0, if a bit error occurs in the sign bit, an encoded value obtained after the bit error is very likely to be 1, and this bit error is tolerable; an encoded value obtained after the bit error is slightly likely to be 2 or 3, and this bit error is intolerable. Similarly, for a sign bit whose preset value is 3, if a bit error occurs in the sign bit, an encoded value obtained after the bit error is very likely to be 2, and this bit error is tolerable; an encoded value obtained after the bit error is slightly likely to be 0 or 1, and this bit error is intolerable. Therefore, when the value of each sign bit in the first sign bit sequence is 2 or 3, the preset value of each sign bit in the first sign bit sequence is determined as 3. When the value of each sign bit in the first sign bit sequence is 0 or 1, the preset value of each sign bit in the first sign bit sequence is determined as 0. A preset value of each sign bit in the second sign bit sequence is also determined in this way.

In a possible implementation, for the frame marker encoding sequence, a bit error is also very likely to occur in the first several sign bits in the frame marker encoding sequence. However, if an error tolerance degree of the frame marker encoding sequence is too high, a non-frame marker encoding sequence may be identified as the frame marker encoding sequence. For a PAM4 encoding sequence, for a sign bit whose preset value is 3, if a bit error occurs in the sign bit, an encoded value obtained after the bit error is very likely to be 2, and this bit error is tolerable. Therefore, when the first encoding sequence is a PAM4 encoding sequence, and the first encoding sequence is similar to the frame marker encoding sequence of the training frame, the target sign bit may include the first p sign bits in the first encoding sequence, where p is greater than or equal to 1 and less than or equal to a first threshold.

In a possible implementation, for a PAM4 encoding sequence, for a sign bit whose preset value is 0, if a bit error occurs in the sign bit, an encoded value obtained after the bit error is very likely to be 1, and this bit error is tolerable. Similarly, for a sign bit whose preset value is 3, if a bit error occurs in the sign bit, an encoded value obtained after the bit error is very likely to be 2, and this bit error is tolerable. Therefore, if the first encoding sequence is a PAM4 encoding sequence, during specific implementation of "parsing, if a value of a target sign bit is different from a preset value in the first encoding sequence, the first encoding sequence based on the fact that the value of the target sign bit is equal to the preset value of the target sign bit", for example, a difference between the value of the target sign bit and the preset value of the target sign bit may be determined. If the difference is equal to 1, the first encoding sequence is parsed based on the fact that the value of the target sign bit is equal to the preset value of the target sign bit. Otherwise, it may be considered that the parsing fails, and the first encoding sequence is discarded.

According to a second aspect, an embodiment of this application provides a data processing apparatus. The apparatus includes an obtaining unit and a parsing unit. The obtaining unit is configured to obtain a first encoding sequence. The parsing unit is configured to parse, if a value of a target sign bit is different from a preset value of the target sign bit in the first encoding sequence, the first encoding sequence based on the fact that the value of the target sign bit is equal to the preset value of the target sign bit.

In a possible implementation, the parsing unit is specifically configured to: if the value of the target sign bit is different from the preset value of the target sign bit in the first encoding sequence, determine the first encoding sequence as a frame marker encoding sequence of a training frame.

In a possible implementation, the parsing unit is specifically configured to: if the value of the target sign bit is different from the preset value of the target sign bit in the first encoding sequence, encode the first encoding sequence to obtain a second encoding sequence.

In a possible implementation, the first encoding sequence includes a control field encoding sequence of a training frame and/or a status field encoding sequence of the training frame.

In a possible implementation, the first encoding sequence is a non-return-to-zero encoding sequence or a four-level pulse amplitude modulation encoding sequence.

In a possible implementation, the target sign bit includes m+n sign bits in the first encoding sequence and/or the last k sign bits in the first encoding sequence, where m is greater than or equal to 0, n is greater than or equal to 0, and k is greater than or equal to 1 and less than or equal to a second threshold. When m+n is equal to 1, the target sign bit includes a first sign bit or a second sign bit, a preset value of the first sign bit is different from a preset value of the second sign bit, and the first sign bit is adjacent to the second sign bit. When m+n is greater than 1, the m+n sign bits are consecutive, preset values of the first m sign bits in the m+n sign bits are the same, preset values of the last n sign bits in the m+n sign bits are the same, and the preset values of the first m sign bits are different from the preset values of the last n sign bits.

In a possible implementation, m is equal to n.

In a possible implementation, the first encoding sequence includes a first encoding sub-sequence, the first encoding sub-sequence includes 2*i sign bits, the first encoding sub-sequence is used to indicate logical bit information, and the target sign bit includes any one or more of the following sign bits: the 1^{st} sign bit in the first encoding sub-sequence, the i^{th} sign bit in the first encoding sub-sequence, the (i+1)^{th} sign bit in the first encoding sub-sequence, and the (2*i)^{th} sign bit in the first encoding sub-sequence.

In a possible implementation, i is greater than or equal to 3, a preset value of the 1^{st} sign bit and a preset value of the i^{th} sign bit are determined based on a preset value of a sign bit between the 1^{st} sign bit and the i^{th} sign bit, and a preset value of the (i+1)^{th} sign bit and a preset value of the (2*i)^{th} sign bit are determined based on a preset value of a sign bit between the (i+1)^{th} sign bit and the (2*i)^{th} sign bit.

In a possible implementation, if the first encoding sequence is a four-level pulse amplitude modulation encoding sequence, the target sign bit further includes a first sign bit sequence or a second sign bit sequence. The first sign bit sequence includes the 2^{nd} sign bit to the (i-1)^{th} sign bit in the first encoding sub-sequence, and the second sign bit sequence includes the (i+1)^{th} sign bit to the (2*i-1)^{th} sign bit in the first encoding sub-sequence.

In a possible implementation, a preset value of each sign bit in the first sign bit sequence is determined in the following manner: if a value of each sign bit in the first sign bit sequence is 0 or 1, determining that the preset value of each sign bit in the first sign bit sequence is 0; or if a value of each sign bit in the first sign bit sequence is 2 or 3, determining that the preset value of each sign bit in the first sign bit sequence is 3. A preset value of each sign bit in the second sign bit sequence is determined in the following manner: if a value of each sign bit in the second sign bit sequence is 0 or 1, determining that the preset value of each sign bit in the second sign bit sequence is 0; or if a value of each sign bit in the second sign bit sequence is 2 or 3, determining that the preset value of each sign bit in the second sign bit sequence is 3.

In a possible implementation, when the first encoding sequence is a four-level pulse amplitude modulation encoding sequence, the target sign bit includes the first p sign bits in the first encoding sequence, where p is greater than or equal to 1 and less than or equal to a first threshold.

In a possible implementation, when the first encoding sequence is a four-level pulse amplitude modulation encoding sequence, the parsing unit is specifically configured to: if a difference between the value of the target sign bit and the preset value of the target sign bit is equal to 1, parse the first encoding sequence based on the fact that the value of the target sign bit is equal to the preset value of the target sign bit.

According to a third aspect, an embodiment of this application provides a data processing device. The data processing device includes a processor and a memory. The memory is configured to store instructions or a computer program. The processor is configured to execute the instructions or the computer program in the memory to perform the method according to any implementation of the first aspect.

According to a fourth aspect, an embodiment of this application provides a computer-readable storage medium, including instructions or a computer program. When the computer-readable storage medium runs on a computer, the computer is enabled to perform the method according to any implementation of the first aspect.

According to a fifth aspect, an embodiment of this application provides a computer program product including instructions or a computer program. When the computer program product runs on a computer, the computer is enabled to perform the method according to any implementation of the first aspect.

### BRIEF DESCRIPTION OF DRAWINGS

To describe the technical solutions in embodiments of this application or in the conventional technology more clearly, the following briefly describes the accompanying drawings required in embodiments or the conventional technology. It is clear that the accompanying drawings in the following descriptions show some embodiments of this application, and persons of ordinary skill in the art may still derive other drawings from these accompanying drawings without creative efforts.
FIG. 1 is a schematic diagram of an example application scenario according to an embodiment of this application;
FIG. 2 is a schematic flowchart of a data processing method according to an embodiment of this application;
FIG. 3 is a schematic diagram of a structure of a data processing apparatus according to an embodiment of this application; and
FIG. 4 is a schematic diagram of a structure of a data processing device according to an embodiment of this application.

### DESCRIPTION OF EMBODIMENTS

Embodiments of this application provide a data processing method and apparatus, to resolve a problem that an effect of optimizing SerDes performance by transferring a training frame between interfaces is not good in the conventional technology.

For ease of understanding, an application scenario of embodiments of this application is first briefly described.

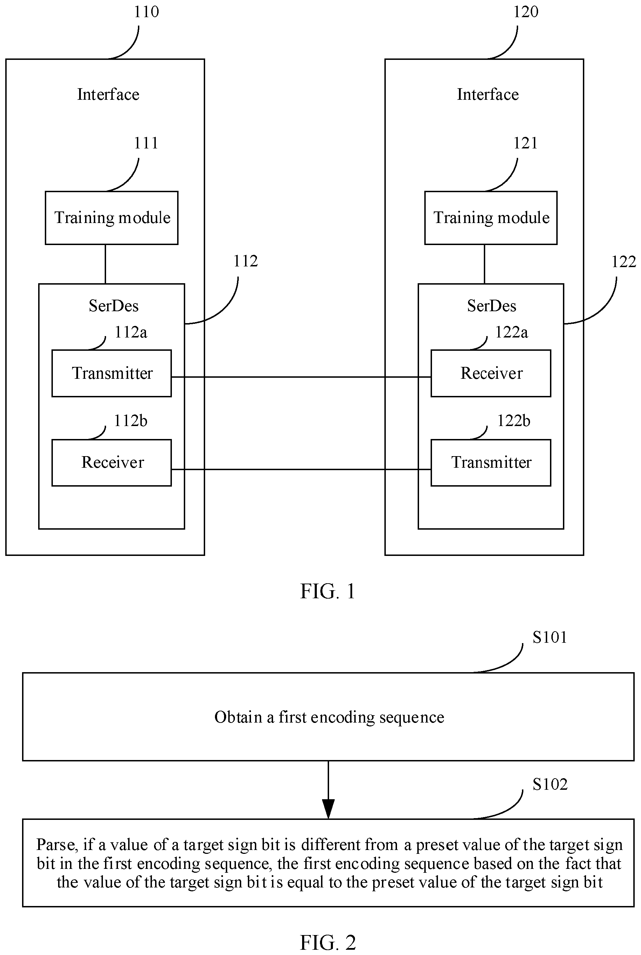

FIG. 1 is a schematic diagram of an example application scenario according to an embodiment of this application.

In the scenario shown in FIG. 1, data may be transferred between an interface 110 and an interface 120. As shown in FIG. 1, the interface 110 includes a training module 111 and a SerDes 112. The SerDes 112 includes a transmitter (transmitter) 112a and a receiver (receiver) 112b. The interface 120 includes a training module 121 and a SerDes 122. The SerDes 122 includes a transmitter 122b and a receiver 122a. When the interface 110 transfers data to the interface 120, the interface 110 may send the data to the interface 120 by using the transmitter 112a of the interface 110, and the interface 120 receives the data from the interface 110 by using the receiver 122a. Similarly, when the interface 120 transfers data to the interface 110, the interface 120 may send the data to the interface 110 by using the transmitter 122b, and the interface 110 receives the data from the interface 120 by using the receiver 112b.

To improve performance of data transmission between the interface 110 and the interface 120, the interface 110 and the interface 120 may adjust a related parameter of a SerDes by transferring a training frame. For example, the interface 110 may send a first training frame to the interface 120, the interface 120 feeds back a second training frame to the interface 110 based on the first training frame received from the interface 110, and the training module 111 of the interface 110 may parse the second training frame, and adjust a related parameter of the SerDes 112 based on a parsing result, for example, adjust an equalizer coefficient (equalizer coefficient) of the transmitter of the interface 110. Similarly, the training module of the interface 120 may also be configured to adjust a related parameter of the SerDes 122. Details are not described herein again.

It should be noted that both the interface 110 and the interface 120 may be Ethernet interfaces, and the interface 110 and the interface 120 each may include at least a media access control (media access control, MAC) layer, a physical coding sublayer (physical coding sublayer, PCS), a physical medium attachment (physical medium attachment, PMA) sublayer (sublayer), and a physical medium dependent (Physical Medium Dependent, PMD) sublayer. The SerDes in this embodiment of this application, for example, the SerDes 112 and the SerDes 122 shown in FIG. 1, is located at the PMD sublayer. A transmission medium between the interface 110 and the interface 120 may be a cable or a copper cable.

Currently, the Institute of Electrical and Electronics Engineers (Institute of Electrical and Electronics Engineers, IEEE) specifies a frame structure and an encoding scheme of a training frame. Both IEEE Std 802.3^{™}-2018 Clause 72 and IEEE Std 802.3cd^{™}-2018 Clause 136 specify that the training frame includes a frame marker (frame marker), a control field (control field), a status field (status field), and a training sequence (one or more training patterns).

Specifically, IEEE Std 802.3^{™}-2018 Clause 72 specifies the following:
1. The training frame is encoded by using non-return-to-zero (non-return-to-zero, NRZ) code.
2. The frame marker includes 32 sign bits, values of the first 16 sign bits are all 1, and values of the last 16 sign bits are all 0. The frame marker is used to indicate a start of the training frame, and there is no frame marker in the control field, the status field, and the training sequence.
3. Bits of the control field (Coefficient update) and the status field (Status report) are represented by using differential Manchester encoding (DME) cells. During transmission, a change of Manchester code in one period indicates transmission 1, and no change indicates transmission 0. Both the control field and the status field use eight sign bits to indicate logical bit information. When values of the eight sign bits are "1111 1111" or "0000 0000", a value of the indicated logical bit information is 0; or when values of the eight sign bits are "1111 0000" or "0000 1111", a value of the indicated logical bit information is 1.

IEEE Std 802.3cd^{™}-2018 Clause 136 specifies the following:
1. The training frame is encoded through four-level pulse amplitude modulation (four-level pulse amplitude modulation, PAM4).
2. The frame marker includes 32 sign bits, values of the first 16 sign bits are all 3, and values of the last 16 sign bits are all 0. The frame marker is used to indicate a start of the training frame, and there is no frame marker in the control field, the status field, and the training sequence.
3. Bits of the control field (Control field) and the status field (Status field) are represented by using four-level pulse amplitude modulation (PAM4) cells. Both the control field and the status field use eight symbol (symbol) bits to indicate logical bit information. When values of the eight sign bits are "3333 3333" or "0000 0000", a value of the indicated logical bit information is 0; or when values of the eight sign bits are "3333 0000" or "0000 3333", a value of the indicated logical bit information is 1.

When a training frame is transferred between interfaces, a bit error may inevitably occur. For example, an encoding sequence sent by the interface 110 is "1111 1111 1111 1111 0000 0000 0000 0000", in other words, the encoding sequence sent by the interface 110 is a frame marker encoding sequence, but an encoding sequence received by the interface 120 is "1111 1111 1111 1111 1000 0000 0000 0000", in other words, a bit error occurs in the encoding sequence received by the interface 120. In this case, the interface 120 does not identify the received encoding sequence as the frame marker (frame marker) encoding sequence. The interface 120 does not identify an encoding sequence after the encoding sequence "1111 1111 1111 1111 0000 0000 0000 0000" as the control field (control field) encoding sequence either. Consequently, the interface 120 cannot obtain the complete first training frame through correct parsing. Correspondingly, the interface 120 cannot return the second training frame to the interface 110 either. Consequently, the interface 110 cannot adjust the equalizer coefficient of the transmitter based on the second training frame, and the interface 110 cannot optimize SerDes performance in time. Similarly, if a bit error occurs in the control field and the status field of the training frame, the foregoing problem is also caused. Consequently, a training frame encoding sequence needs to be repeatedly transferred between the interface 110 and the interface 120, and it is difficult to achieve an objective of optimizing SerDes performance.

The interface 110 and the interface 120 herein may be interfaces that support the IEEE 802.3 and IEEE 802.3cd standards. The interface 110 may be a 10GBASE-KR interface, a 40GBASE-KR4 interface, a 40GBASE-CR4 interface, a 25GBASE-KR interface, a 25GBASE-CR interface, a 50GBASE-KR2 interface, a 50GBASE-CR2 interface, a 100GBASE-KR4 interface, a 100GBASE-CR4 interface, a 50GBASE-CR interface, a 100GBASE-CR2 interface, a 200GBASE-CR4 interface, or the like. Correspondingly, the interface 120 also may be a 10GBASE-KR interface, a 40GBASE-KR4 interface, a 40GBASE-CR4 interface, a 25GBASE-KR interface, a 25GBASE-CR interface, a 50GBASE-KR2 interface, a 50GBASE-CR2 interface, a 100GBASE-KR4 interface, a 100GBASE-CR4 interface, a 50GBASE-CR interface, a 100GBASE-CR2 interface, a 200GBASE-CR4 interface, or the like.

Embodiments of this application provide a data processing method, so that an interface that receives a training frame can still correctly parse the training frame when a few bit errors occur in the training frame. With reference to the accompanying drawings, the following describes the data processing method provided in embodiments of this application.

FIG. 2 is a schematic flowchart of a data processing method according to an embodiment of this application. For example, the data processing method shown in FIG. 2 may be implemented by performing S101 and S102. An example in which the method shown in FIG. 2 is performed by a first interface is used for description.

S101: Obtain a first encoding sequence.

In this embodiment of this application, the first encoding sequence may be from a second interface. Specifically, the first encoding sequence may be obtained by encoding a voltage signal sent by the second interface. The first interface and the second interface may be located on different devices. In some embodiments, the device may be a network device, a server, a storage device, or the like. The network device may be a switch or a router.

The first encoding sequence is not specifically limited in this embodiment of this application. Corresponding to the application scenario shown in FIG. 1, the first encoding sequence may be one or more of a frame marker encoding sequence of a training frame, a control field encoding sequence of the training frame, and a status field encoding sequence of the training frame.

The first encoding sequence may include a plurality of sign bits, and one sign bit may include one or more bits. Specifically, a quantity of bits included in one sign bit is determined based on an encoding scheme of the first encoding sequence. For example, IEEE Std 802.3^{™}-2018 Clause 72 specifies that the training frame is encoded by using NRZ code. Because the NRZ code has only two values: 1 and 0, if the first encoding sequence is an NRZ encoding sequence, one sign bit may include one bit, and a value of the one bit may be 1 or 0. IEEE Std 802.3cd^{™}-2018 Clause 136 specifies that the training frame is encoded through PAM4. Because PAM4 code has four values: 0, 1, 2, and 3, if the first encoding sequence is a PAM4 encoding sequence, one sign bit may include two bits, and values of the two bits may be 00, 01, 10, and 11. In this embodiment of this application, the first encoding sequence may be an NRZ encoding sequence, that is, an encoding sequence that is encoded through NRZ encoding, or may be a PAM4 encoding sequence, that is, an encoding sequence that is encoded through PAM4. The encoding scheme of the first encoding sequence may be determined by the first interface and the second interface through auto negotiation (auto negotiation, AN). After the auto negotiation, the second interface may send the first encoding sequence to the first interface based on a negotiation result.

S102: Parse, if a value of a target sign bit is different from a preset value of the target sign bit in the first encoding sequence, the first encoding sequence based on the fact that the value of the target sign bit is equal to the preset value of the target sign bit.

After obtaining the first encoding sequence, the first interface may parse the first encoding sequence to determine information that is carried by the first encoding sequence. A signal sent by the second interface to the first interface is a voltage signal. When a voltage value sent by the second interface to the first interface jumps, a bit error is likely to occur in an encoded value received by the first interface, and the bit error is tolerable. However, in the conventional technology, once a bit error occurs in the first encoding sequence, the first interface cannot correctly parse the first encoding sequence. Consequently, an effect of optimizing SerDes performance by transferring the training frame between the first interface and the second interface is affected. In this embodiment of this application, for the target sign bit in the first encoding sequence, if the value of the target sign bit is different from the preset value of the target sign bit, the first encoding sequence may be parsed based on the fact that the value of the target sign bit is equal to the preset value of the target sign bit. The target sign bit is one or more sign bits in which a bit error is likely to occur.

For the preset value of the target sign bit, it should be noted that, in some embodiments, the voltage signal sent by the second interface to the first interface needs to comply with a protocol specification. For the training frame, the protocol may be IEEE Std 802.3^{™}-2018 Clause 72 or IEEE Std 802.3cd^{™}-2018 Clause 136. Correspondingly, a value of each sign bit in the first encoding sequence also complies with a specific rule. The preset value of the target sign bit is a theoretical value that complies with the protocol specification.

A preset value of one sign bit is described by using an example.

IEEE Std 802.3^{™}-2018 specifies that a frame marker of the training frame encoded by using the NRZ code is "1111 1111 1111 1111 0000 0000 0000 0000", preset values corresponding to the 1^{st} sign bit to the 16^{th} sign bit in the frame marker encoding sequence are all 1, and preset values corresponding to the 17^{th} sign bit to the 32^{nd} sign bit in the frame marker encoding sequence are all 0. The control field encoding sequence and the status field encoding sequence of the training frame use eight sign bits to indicate logical bit information. Values of the eight sign bits are also specified in IEEE Std 802.3^{™}-2018, to be specific, may be "1111 1111", "0000 0000", "1111 0000", or "0000 1111". For the control field encoding sequence and the status field encoding sequence of the training frame, in the eight sign bits indicating the logical bit information, preset values of the first four sign bits are the same, and the preset values may be 0 or 1. Preset values of the last four sign bits are also the same, and the preset values may be 0 or 1. When a value of the logical bit information is 1, the preset values of the first four sign bits are different from the preset values of the last four sign bits; or when a value of the logical bit information is 0, the preset values of the first four sign bits are the same as the preset values of the last four sign bits.

IEEE Std 802.3cd^{™}-2018 specifies that a format of a frame marker of the training frame encoded through PAM4 is "3333 3333 3333 3333 0000 0000 0000 0000", preset values corresponding to the 1^{st} sign bit to the 16^{th} sign bit in the frame marker encoding sequence are all 3, and preset values corresponding to the 17^{th} sign bit to the 32^{nd} sign bit in the frame marker encoding sequence are all 0. The control field encoding sequence and the status field encoding sequence of the training frame use eight sign bits to indicate logical bit information. 802.3cd^{™}-2018 specifies that values of the eight sign bits may be "3333 3333", "0000 0000", "3333 0000", or "0000 3333". For the control field encoding sequence and the status field encoding sequence of the training frame, in the eight sign bits indicating the logical bit information, preset values of the first four sign bits are the same, and the preset values may be 0 or 3. Preset values of the last four sign bits are also the same, and the preset values may be 0 or 3. When a value of the logical bit information is 1, the preset values of the first four sign bits are different from the preset values of the last four sign bits, in other words, the eight sign bits are 0000 3333 or 3333 0000; or when a value of the logical bit information is 0, the preset values of the first four sign bits are the same as the preset values of the last four sign bits, in other words, the eight sign bits are 0000 0000 or 3333 3333.

Parsing the first encoding sequence in this embodiment of this application may include at least one of the following two aspects. The first aspect means identifying whether the first encoding sequence is the frame marker encoding sequence of the training frame. Specifically, when the first encoding sequence includes 16 sign bits, a bit error may occur in a target sign bit in the 16 sign bits, and the other sign bits comply with the protocol specification on the frame marker, the first interface may determine the first encoding sequence as the frame marker encoding sequence of the training frame, instead of discarding the first encoding sequence like in the conventional technology. For example, if the encoding scheme of the first encoding sequence is NRZ, when the first interface determines that a value of a sign bit other than the target sign bit complies with the specification of IEEE Std 802.3^{™}-2018 Clause 72, the first interface may determine the first encoding sequence as the frame marker encoding sequence of the training frame. For another example, if the encoding scheme of the first encoding sequence is PAM4, when the first interface determines that a value of a sign bit other than the target sign bit complies with the specification of IEEE Std 802.3cd^{™}-2018 Clause 136, the first interface may determine the first encoding sequence as the frame marker encoding sequence of the training frame.

As described above, both the control field encoding sequence and the status field encoding sequence of the training frame use eight sign bits to indicate logical bit information. Therefore, the second aspect means that, when the first encoding sequence includes the status field encoding sequence or the control field encoding sequence, the first interface encodes the first encoding sequence to obtain a second encoding sequence. The second encoding sequence herein may be used to indicate the logical bit information indicated by the status field encoding sequence or the control field encoding sequence.

It can be learned from the foregoing descriptions that, according to the solution in this embodiment of this application, for the target sign bit in which a bit error is likely to occur, if a bit error occurs in the target sign bit, in other words, the value of the target sign bit is different from the preset value of the target sign bit, the first interface may also correctly parse the first encoding sequence.

When the voltage value sent by the second interface to the first interface jumps, a bit error is likely to occur in the encoded value received by the first interface. The target sign bit includes one or more sign bits in which a bit error is likely to occur. The following specifically describes the target sign bit.

In some embodiments, in the frame marker encoding sequence of the training frame, voltage values corresponding to the first 16 sign bits are the same, voltage values corresponding to the last 16 sign bits are the same, and the voltage values corresponding to the first 16 sign bits are different from the voltage values corresponding to the last 16 sign bits. In this case, a bit error is likely to occur in the 16^{th} sign bit and the 17^{th} sign bit that are received by the first interface. In addition, the inventor finds, through research, that a bit error is also likely to occur in a sign bit that is close to the 16^{th} sign bit, for example, the 15^{th} sign bit and the 14^{th} sign bit. Correspondingly, a bit error is also likely to occur in a sign bit that is close to the 17^{th} sign bit, for example, the 18^{th} sign bit and the 19^{th} sign bit. Therefore, when the first encoding sequence obtained by the first interface is similar to the frame marker encoding sequence of the training frame, for example, if the first interface and the second interface determine an encoding scheme of the training frame as NRZ through auto negotiation, and the first encoding sequence is similar to the frame marker encoding sequence specified in IEEE Std 802.3^{™}-2018 Clause 72, or if the first interface and the second interface determine an encoding scheme of the training frame as PAM4 through auto negotiation, and the first encoding sequence is similar to the frame marker encoding sequence specified in IEEE Std 802.3cd^{™}-2018 Clause 136, that the first interface parses the first encoding sequence includes determining whether the first encoding sequence is the frame marker encoding sequence of the training frame. In this case, the target sign bit may include m+n sign bits, where both m and n are integers greater than or equal to 0.

Specifically, when m+n is equal to 1, the target sign bit includes one sign bit. In this case, the target sign bit may include a first sign bit or a second sign bit, the first sign bit is adjacent to the second sign bit, and a preset value of the first sign bit is different from a preset value of the second sign bit. The first sign bit herein may be, for example, the 16^{th} sign bit above, and the second sign bit herein may be, for example, the 17^{th} sign bit above. For example, for a training frame encoded by using NRZ code, when the first encoding sequence received by the first interface is "1111 1111 1111 111Y 0000 0000 0000 0000" or "1111 1111 1111 1111 Y000 0000 0000 0000", the first interface may parse the first encoding sequence based on "1111 1111 1111 1111 0000 0000 0000 0000", where a value of Y may be 1 or 0. For another example, for a training frame encoded through PAM4, when the first encoding sequence received by the first interface is "3333 3333 3333 333X 0000 0000 0000 0000" or " 3333 3333 3333 X000 0000 0000 0000", the first interface may parse the first encoding sequence based on "3333 3333 3333 3333 0000 0000 0000 0000", where a value of X may be any one of 0, 1, 2, and 3.

When m+n is greater than 1, the target sign bit may include m+n consecutive sign bits, preset values of the first m sign bits in the m+n consecutive sign bits are the same, preset values of the last n sign bits in the m+n consecutive sign bits are the same, and the preset values of the first m sign bits are different from the preset values of the last n sign bits. In other words, the last sign bit in the first m consecutive sign bits may be the first sign bit, and the 1^{st} sign bit in the last n consecutive sign bits may be the second sign bit. Specific values of m and n are not specifically limited in this embodiment of this application. In some embodiments, when the voltage value sent by the second interface jumps, sign bits in which a bit error occurs in the encoded value received by the first interface are symmetric. In other words, a quantity of sign bits in which a bit error is likely to occur before a level jump is the same as a quantity of sign bits in which a bit error is likely to occur after the level jump. Therefore, in some embodiments, m and n may be the same. For example, values of m and n are both 1. For another example, values of m and n are both 2. For still another example, values of m and n are both 3.

In this case, for example, if the first encoding sequence is an NRZ encoding sequence, when the first encoding sequence received by the first interface is "1111 1111 1111 11YY 0000 0000 0000 0000", "1111 1111 1111 1111 YY00 0000 0000 0000", "1111 1111 1111 1YYY 0000 0000 0000 0000", "1111 1111 1111 1111 YYY0 0000 0000 0000", "1111 1111 1111 111Y Y000 0000 0000 0000", "1111 1111 1111 11YY YY00 0000 0000 0000", or "1111 1111 1111 1YYY YYY0 0000 0000 0000", the first interface may parse the first encoding sequence based on "1111 1111 1111 1111 0000 0000 0000 0000", where a value of Y may be 1 or 0. For another example, if the first encoding sequence is a PAM4 encoding sequence, when the first encoding sequence received by the first interface is "3333 3333 3333 33XX 0000 0000 0000 0000", "3333 3333 3333 3333 XX00 0000 0000 0000", "3333 3333 3333 3XXX 0000 0000 0000 0000", "3333 3333 3333 3333 XXX0 0000 0000 0000", "3333 3333 3333 333X X000 0000 0000 0000", "3333 3333 3333 33XX XX00 0000 0000 0000", or "3333 3333 3333 3XXX XXX0 0000 0000 0000", the first interface may parse the first encoding sequence based on "3333 3333 3333 3333 0000 0000 0000 0000", where a value of X may be any one of 0, 1, 2, and 3.

In addition, the control field encoding sequence follows the frame marker encoding sequence of the training frame, and a value of the 1^{st} sign bit in the control field encoding sequence may also be different from a value of the last sign bit in the frame marker encoding sequence. Therefore, a bit error is also likely to occur in the last sign bit in the frame marker encoding sequence. The inventor finds, through research, that a bit error is also likely to occur in a sign bit that is close to the last sign bit in the frame marker encoding sequence, for example, the second-to-last sign bit and the third-to-last sign bit in the frame marker encoding sequence. In view of this, if the first encoding sequence is similar to the frame marker encoding sequence of the training frame, the target sign bit may include the last k sign bits in first encoding sequence, where k is an integer greater than or equal to 1. For example, a value of k may be 1, 2, or 3. For example, if the first encoding sequence is an NRZ encoding sequence, when the first encoding sequence received by the first interface is "1111 1111 1111 1111 0000 0000 0000 000Y", "1111 1111 1111 11110000 0000 0000 00YY", or "1111 1111 1111 1111 0000 0000 0000 0YYY", the first interface may parse the first encoding sequence based on "1111 1111 1111 1111 0000 0000 0000 0000", where a value of Y may be 1 or 0. For another example, if the first encoding sequence is a PAM4 encoding sequence, when the first encoding sequence received by the first interface is "3333 3333 3333 3333 0000 0000 0000 000X", "3333 3333 3333 0000 0000 0000 00XX", or "3333 3333 3333 0000 0000 0000 0XXX", the first interface may parse the first encoding sequence based on "3333 3333 3333 3333 0000 0000 0000 0000", where a value of X may be any one of 0, 1, 2, and 3.

Both the control field encoding sequence and the status field encoding sequence of the training frame use eight sign bits to indicate logical bit information. If values of the first four sign bits are the same as values of the last four sign bits, a value of the logical bit information indicated by the eight sign bits is 0; or if values of the first four sign bits are different from values of the last four sign bits, a value of the logical bit information indicated by the eight sign bits is 1. In this embodiment of this application, 2*i sign bits indicating the logical bit information are referred to as a first encoding sub-sequence. If the first encoding sub-sequence is the control field encoding sequence or the status field encoding sequence of the training frame, a value of i may be equal to 4. A value of the logical bit information indicated by the first encoding sub-sequence may be 0 or 1. Therefore, a voltage value corresponding to the i^{th} sign bit may be different from a voltage value corresponding to the (i+1)^{th} sign bit in the first encoding sub-sequence. In this case, a bit error may occur in both the i^{th} sign bit and the (i+1)^{th} sign bit in the first encoding sub-sequence. In addition, the control field encoding sequence of the training frame may include one or more first encoding sub-sequences, and values of logical bits indicated by two adjacent first encoding sub-sequences may be the same or may be different. In other words, a value of the last sign bit in a current first encoding sub-sequence may be different from a value of the 1^{st} sign bit in a next first encoding sub-sequence. In this case, a bit error may occur in both the 1^{st} sign bit and the last sign bit, namely, the (2*i)^{th} sign bit, in the first encoding sub-sequence. Therefore, the target sign bit may include any one or more of the 1^{st} sign bit in the first encoding sub-sequence, the i^{th} sign bit in the first encoding sub-sequence, the (i+1)^{th} sign bit in the first encoding sub-sequence, and the (2*i)^{th} sign bit in the first encoding sub-sequence.

A difference from the frame marker encoding sequence is that a specific value of each sign bit in the first encoding sub-sequence is not specified in IEEE Std 802.3^{™}-2018 Clause 72 and IEEE Std 802.3cd^{™}-2018 Clause 136, but the value of each sign bit in the first encoding sub-sequence needs to comply with a rule that values of the first i sign bits are the same and values of the last i sign bits are the same. In this embodiment of this application, the first interface may determine a preset value of the 1^{st} sign bit and a preset value of the i^{th} sign bit based on a preset value of a sign bit between the 1^{st} sign bit and the i^{th} sign bit. In an embodiment, an actual value of the sign bit between the 1^{st} sign bit and the i^{th} sign bit may be determined as the preset value of the sign bit between the 1^{st} sign bit and the i^{th} sign bit. For example, if the values of the first i sign bits in the first encoding sub-sequence are "Y00Y", the first interface may determine preset values of the 2^{nd} sign bit and the 3^{rd} sign bit as 0, and further determine both preset values of the 1^{st} sign bit and the 4^{th} sign bit as 0. For another example, if the values of the first i sign bits in the first encoding sub-sequence are "X33X", the first interface may determine preset values of the 2^{nd} sign bit and the 3^{rd} sign bit as 3, and further determine both preset values of the 1^{st} sign bit and the 4^{th} sign bit as 3. Correspondingly, a preset value of the (i+1)^{th} sign bit and a preset value of the (2*i)^{th} sign bit are determined based on a preset value of a sign bit between the (i+1)^{th} sign bit and the (2*i)^{th} sign bit. Details are not described herein again.

In this embodiment of this application, if the first encoding sequence is a PAM4 encoding sequence, a value of each sign bit in the status field encoding sequence and the control field encoding sequence of the training frame may be only 0 or 3. In addition, if the first encoding sequence is the status field encoding sequence or the control field encoding sequence, it indicates that the first interface has successfully received the frame marker encoding sequence of the training frame from the second interface. In this case, to further improve an effect of optimizing SerDes performance by transferring the training frame between the first interface and the second interface, in some embodiments, for the control field encoding sequence and the status field encoding sequence of the training frame, error tolerance may be further relaxed. Specifically, the target sign bit may further include a first sign bit sequence and a second sign bit sequence. The first sign bit sequence includes the 2^{nd} sign bit to the (i-1)^{th} sign bit in the first encoding sub-sequence, and the second sign bit sequence includes the (i+1)^{th} sign bit to the (2*i-1)^{th} sign bit in the first encoding sub-sequence. Herein, a value of i is an integer greater than or equal to 3. For example, the value of i may be 4.

In addition, it is considered that the preset value of the 1^{st} sign bit and the preset value of the i^{th} sign bit are determined based on a value of each sign bit in the first sign bit sequence, and the preset value of the (i+1)^{th} sign bit and the preset value of the (2*i)^{th} sign bit are determined based on a value of each sign bit in the second sign bit sequence. If a bit error occurs in a sign bit in the first sign bit sequence, an actual value of the sign bit in the first sign bit sequence cannot be determined as a preset value of the sign bit in the first sign bit sequence, and consequently the preset value of the 1^{st} sign bit and the preset value of the i^{th} sign bit cannot be determined. Correspondingly, if a bit error occurs in a sign bit in the second sign bit sequence, the preset value of the (i+1)^{th} sign bit and the preset value of the (2*i)^{th} sign bit cannot be determined. To resolve this problem, in this embodiment of this application, a preset value of each sign bit in the first sign bit sequence may be determined based on the value of each sign bit in the first sign bit sequence. It should be noted that, for the PAM4 code, for a sign bit whose preset value is 0, if a bit error occurs in the sign bit, an encoded value obtained after the bit error is very likely to be 1, and this bit error is tolerable; an encoded value obtained after the bit error is slightly likely to be 2 or 3, and this bit error is intolerable. Similarly, for a sign bit whose preset value is 3, if a bit error occurs in the sign bit, an encoded value obtained after the bit error is very likely to be 2, and this bit error is tolerable; an encoded value obtained after the bit error is slightly likely to be 0 or 1, and this bit error is intolerable. Therefore, in some embodiments, when the value of each sign bit in the first sign bit sequence is 2 or 3, the preset value of each sign bit in the first sign bit sequence is determined as 3. When the value of each sign bit in the first sign bit sequence is 0 or 1, the preset value of each sign bit in the first sign bit sequence is determined as 0. A preset value of each sign bit in the second sign bit sequence is also determined in this way. For example, when a value of the first sign bit sequence is "22", it may be considered that a preset value of the first sign bit sequence is "33"; or when a value of the first sign bit sequence is "11", it may be considered that a preset value of the first sign bit sequence is "00". In other words, when the first encoding sub-sequence received by the first interface is "X22X X11X", the first interface may parse the first encoding sub-sequence based on "3333 0000".

In some embodiments, for a PAM4 encoding sequence, for a sign bit whose preset value is 0, if a bit error occurs in the sign bit, an encoded value obtained after the bit error is very likely to be 1, and this bit error is tolerable. Similarly, for a sign bit whose preset value is 3, if a bit error occurs in the sign bit, an encoded value obtained after the bit error is very likely to be 2, and this bit error is tolerable. Therefore, if the first encoding sequence is a PAM4 encoding sequence, during specific implementation of S102, for example, a difference between the value of the target sign bit and the preset value of the target sign bit may be determined. If the difference is equal to 1, the first encoding sequence is parsed based on the fact that the value of the target sign bit is equal to the preset value of the target sign bit. Otherwise, it may be considered that the parsing fails, and the first encoding sequence is discarded. For example, if the preset value is 0, and the value of the target sign bit is 1, the first encoding sequence is parsed based on the fact that the value of the target sign bit is 1. For another example, if the preset value is 3, and the value of the target sign bit is 2, the first encoding sequence is parsed based on the fact that the value of the target sign bit is 3.

As described above, if the first encoding sequence is similar to the frame marker encoding sequence of the training frame, a bit error is likely to occur in the first sign bit and the second sign bit that are received by the first interface. In addition, a bit error is also likely to occur in a sign bit that is close to the first sign bit, for example, one or two sign bits before the first sign bit. Correspondingly, a bit error is also likely to occur in a sign bit that is close to the second sign bit, for example, one or two sign bits after the second sign bit. In some embodiments, a possibility that a bit error occurs in the first sign bit is higher than a possibility that a bit error occurs in one sign bit before the first sign bit, and a possibility that a bit error occurs in the second sign bit is higher than a possibility that a bit error occurs in one sign bit after the second sign bit. In addition, a possibility that a bit error occurs in the last sign bit is higher than a possibility that a bit error occurs in the second-to-last sign bit. Therefore, if the first encoding sequence is a PAM4 encoding sequence, when the target sign bit includes the m+n consecutive sign bits, or when the target sign bit includes the last k sign bits in the first encoding sequence, different error tolerance degrees may be set for the sign bits, and a sign bit with a higher bit error probability has a higher error tolerance degree. For example, error tolerance granularities of the first sign bit and the second sign bit are the highest, and error tolerance degrees of the one or two sign bits before the first sign bit are relatively low. An error tolerance degree may be determined by using a value of a sign bit. For a sign bit with a high error tolerance degree, regardless of a value of the sign bit, parsing is performed based on a preset value of the sign bit. For a sign bit with a relatively low error tolerance degree, it may be further determined whether a difference between a value of the sign bit and a preset value of the sign bit is equal to 1. When the difference is equal to 1, the first encoding sequence is parsed based on the fact that the value of the sign bit is equal to the preset value.

This may be understood with reference to Table 1. In Table 1, a value of X may be any one of 0, 1, 2, and 3, and x indicates that a difference between a value and a preset value is equal to 1. To be specific, when the preset value is 3, the value of x is 2; or when the preset value is 0, the value of x is 1. When the first encoding sequence is shown in Table 1, the first encoding sequence may be determined as the frame marker encoding sequence.

**Table 1**

| First encoding sequence | Preset value of the first encoding sequence |
|---|---|
| 3333 3333 3333 333X X000 0000 0000 0000 | 3333 3333 3333 3333 0000 0000 0000 0000 |
| 3333 3333 3333 33xX X000 0000 0000 0000 | 3333 3333 3333 3333 0000 0000 0000 0000 |
| 3333 3333 3333 333X Xx00 0000 0000 0000 | 3333 3333 3333 3333 0000 0000 0000 0000 |
| 3333 3333 3333 33xX Xx00 0000 0000 0000 | 3333 3333 3333 3333 0000 0000 0000 0000 |
| 3333 3333 3333 3333 0000 0000 0000 000X | 3333 3333 3333 3333 0000 0000 0000 0000 |
| 3333 3333 3333 3333 0000 0000 0000 00XX | 3333 3333 3333 3333 0000 0000 0000 0000 |
| 3333 3333 3333 3333 0000 0000 0000 0xXX | 3333 3333 3333 3333 0000 0000 0000 0000 |

It should be noted that Table 1 is merely an example for description for ease of understanding, and various cases included in this embodiment of this application are not exhaustively listed. When no conflict occurs, the target sign bit may be a combination of the cases shown in Table 1.

In some embodiments, for the frame marker encoding sequence, a bit error is also very likely to occur in the first several sign bits in the frame marker encoding sequence. However, if an error tolerance degree of the frame marker encoding sequence is too high, a non-frame marker encoding sequence may be identified as the frame marker encoding sequence. Considering the foregoing descriptions, for a PAM4 encoding sequence, for a sign bit whose preset value is 3, if a bit error occurs in the sign bit, an encoded value obtained after the bit error is very likely to be 2, and this bit error is tolerable. However, for an NRZ encoding sequence, a value of each sign bit is only 0 or 1. For an encoding sequence that is similar to the frame marker encoding sequence, it is difficult to determine whether a bit error occurs in the first several sign bits. Therefore, when the first encoding sequence is a PAM4 encoding sequence, and the first encoding sequence is similar to the frame marker encoding sequence of the training frame, the target sign bit may include the first p sign bits in the first encoding sequence, where p is greater than or equal to 1 and less than or equal to a first threshold. The first threshold herein may be, for example, equal to 2 or 3. In an example, when a value of one or more of the current p sign bits is 2, the first encoding sequence may be parsed based on the fact that values of the first p sign bits are all 3.

According to the data processing method provided in this embodiment, embodiments of this application further provide a corresponding apparatus. The following describes the apparatus with reference to the accompanying drawings.

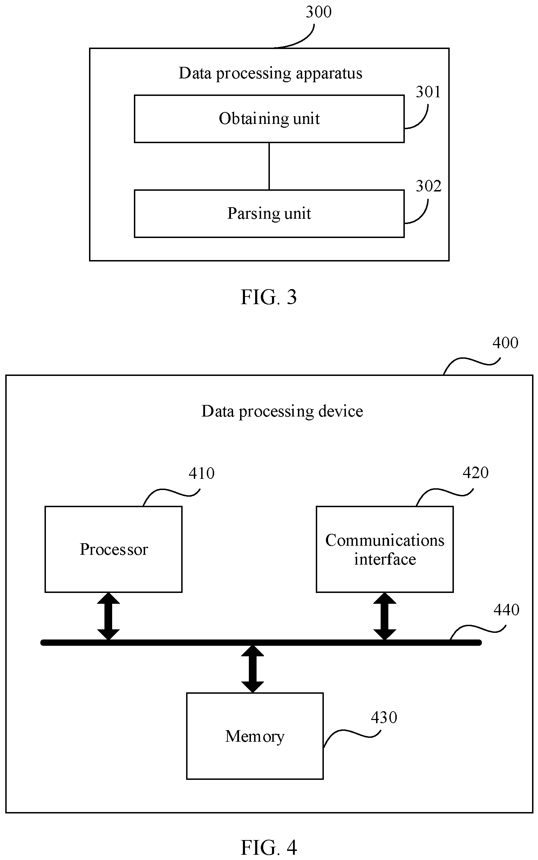

FIG. 3 is a schematic diagram of a structure of a data processing apparatus according to an embodiment of this application. The data processing apparatus 300 shown in FIG. 3 may be configured to perform the data processing method shown in FIG. 2. Specifically, the data processing apparatus 300 may include an obtaining unit 301 and a parsing unit 302.

The obtaining unit 301 is configured to obtain a first encoding sequence. The parsing unit 302 is configured to parse, if a value of a target sign bit is different from a preset value of the target sign bit in the first encoding sequence, the first encoding sequence based on the fact that the value of the target sign bit is equal to the preset value of the target sign bit.

In a possible implementation, the parsing unit 302 is specifically configured to: if the value of the target sign bit is different from the preset value of the target sign bit in the first encoding sequence, determine the first encoding sequence as a frame marker encoding sequence of a training frame.

In a possible implementation, the parsing unit 302 is specifically configured to:
if the value of the target sign bit is different from the preset value of the target sign bit in the first encoding sequence, encode the first encoding sequence to obtain a second encoding sequence.

In a possible implementation, the first encoding sequence includes a control field encoding sequence of a training frame and/or a status field encoding sequence of the training frame.

In a possible implementation, the first encoding sequence is a non-return-to-zero encoding sequence or a four-level pulse amplitude modulation encoding sequence.

In a possible implementation, the target sign bit includes m+n sign bits in the first encoding sequence and/or the last k sign bits in the first encoding sequence, where m is greater than or equal to 0, n is greater than or equal to 0, and k is greater than or equal to 1 and less than or equal to a second threshold. When m+n is equal to 1, the target sign bit includes a first sign bit or a second sign bit, a preset value of the first sign bit is different from a preset value of the second sign bit, and the first sign bit is adjacent to the second sign bit. When m+n is greater than 1, the m+n sign bits are consecutive, preset values of the first m sign bits in the m+n sign bits are the same, preset values of the last n sign bits in the m+n sign bits are the same, and the preset values of the first m sign bits are different from the preset values of the last n sign bits.

In a possible implementation, m is equal to n.

In a possible implementation, the first encoding sequence includes a first encoding sub-sequence, the first encoding sub-sequence includes 2*i sign bits, the first encoding sub-sequence is used to indicate logical bit information, and the target sign bit includes any one or more of the following sign bits: the 1^{st} sign bit in the first encoding sub-sequence, the i^{th} sign bit in the first encoding sub-sequence, the (i+1)^{th} sign bit in the first encoding sub-sequence, and the (2*i)^{th} sign bit in the first encoding sub-sequence.

In a possible implementation, i is greater than or equal to 3, a preset value of the 1^{st} sign bit and a preset value of the i^{th} sign bit are determined based on a preset value of a sign bit between the 1^{st} sign bit and the i^{th} sign bit, and a preset value of the (i+1)^{th} sign bit and a preset value of the (2*i)^{th} sign bit are determined based on a preset value of a sign bit between the (i+1)^{th} sign bit and the (2*i)^{th} sign bit.

In a possible implementation, if the first encoding sequence is a four-level pulse amplitude modulation encoding sequence, the target sign bit further includes a first sign bit sequence or a second sign bit sequence. The first sign bit sequence includes the 2^{nd} sign bit to the (i-1)^{th} sign bit in the first encoding sub-sequence, and the second sign bit sequence includes the (i+1)^{th} sign bit to the (2*i-1)^{th} sign bit in the first encoding sub-sequence.

In a possible implementation, a preset value of each sign bit in the first sign bit sequence is determined in the following manner: if a value of each sign bit in the first sign bit sequence is 0 or 1, determining that the preset value of each sign bit in the first sign bit sequence is 0; or if a value of each sign bit in the first sign bit sequence is 2 or 3, determining that the preset value of each sign bit in the first sign bit sequence is 3. A preset value of each sign bit in the second sign bit sequence is determined in the following manner: if a value of each sign bit in the second sign bit sequence is 0 or 1, determining that the preset value of each sign bit in the second sign bit sequence is 0; or if a value of each sign bit in the second sign bit sequence is 2 or 3, determining that the preset value of each sign bit in the second sign bit sequence is 3.

In a possible implementation, when the first encoding sequence is a four-level pulse amplitude modulation encoding sequence, the target sign bit includes the first p sign bits in the first encoding sequence, where p is greater than or equal to 1 and less than or equal to a first threshold.

In a possible implementation, when the first encoding sequence is a four-level pulse amplitude modulation encoding sequence, the parsing unit 302 is specifically configured to: if a difference between the value of the target sign bit and the preset value of the target sign bit is equal to 1, parse the first encoding sequence based on the fact that the value of the target sign bit is equal to the preset value of the target sign bit.

Because the apparatus 300 is an apparatus corresponding to the data processing method corresponding to FIG. 2 described in the foregoing embodiment, specific implementations of the units in the apparatus 300 and the foregoing method embodiment are based on a same concept. Therefore, for specific implementations of the units in the apparatus 300, refer to the descriptions of the data processing method corresponding to FIG. 2 in the foregoing method embodiment. Details are not described herein again.

It should be noted that a hardware structure of the data processing apparatus 300 may be a structure shown in FIG. 4. FIG. 4 is a schematic diagram of a structure of a data processing device according to an embodiment of this application.

As shown in FIG. 4, the data processing device 400 includes a processor 410, a communications interface 420, and a memory 430. There may be one or more processors 410 in the data processing device 400. One processor is used as an example in FIG. 4. In this embodiment of this application, the processor 410, the communications interface 420, and the memory 430 may be connected by using a bus system or in another manner. In FIG. 4, for example, a bus system 440 is used for connection.

The processor 410 may be a central processing unit (central processing unit, CPU), a network processor (network processor, NP), or a combination of the CPU and the NP. The processor 410 may further include a hardware chip. The hardware chip may be an application-specific integrated circuit (application-specific integrated circuit, ASIC), a programmable logic device (programmable logic device, PLD), or a combination thereof. The PLD may be a complex programmable logic device (complex programmable logic device, CPLD), a field-programmable logic gate array (field-programmable logic gate array, FPGA), generic array logic (generic array logic, GAL), or any combination thereof.

The memory 430 may include a volatile memory (English: volatile memory), such as a random access memory (random access memory, RAM). The memory 430 may alternatively include a nonvolatile memory (English: nonvolatile memory), such as a flash memory (English: flash memory), a hard disk drive (hard disk drive, HDD), or a solid-state drive (solid-state drive, SSD). The memory 430 may alternatively include a combination of the foregoing types of memories. For example, the memory 430 may store a preset value of a frame marker encoding sequence of a training frame, and is configured to store preset values of 2*i sign bits that are used to indicate logical bit information.

Optionally, the memory 430 stores an operating system, a program, and an executable module or a data structure, or a subset thereof, or an extended set thereof. The program may include various operation instructions for implementing various operations. The operating system may include various system programs for implementing various basic services and processing hardware-based tasks. The processor 410 may read the program in the memory 430, to implement the data processing method in this embodiment of this application.

The bus system 440 may be a peripheral component interconnect (peripheral component interconnect, PCI) bus, an extended industry standard architecture (extended industry standard architecture, EISA) bus, or the like. The bus system 440 may be classified into an address bus, a data bus, a control bus, and the like. For ease of representation, only one bold line is used for representation in FIG. 4, but this does not mean that there is only one bus or only one type of bus.

An embodiment of this application further provides a computer-readable storage medium, including instructions or a computer program. When the computer-readable storage medium runs on a computer, the computer is enabled to perform the data processing method in the foregoing embodiment.

An embodiment of this application further provides a computer program product including instructions or a computer program. When the computer program product runs on a computer, the computer is enabled to perform the data processing method in the foregoing embodiment.

The method in this application may be implemented on an Ethernet interface.

The apparatus and the device in this application each may be an Ethernet interface or a part of an Ethernet interface.

This application further provides a device. The device includes the Ethernet interface in the foregoing embodiment.

In this specification, the claims, and the accompanying drawings of this application, terms "first", "second", "third", "fourth", and the like (if existent) are intended to distinguish between similar objects but do not necessarily indicate a specific order or sequence. It should be understood that the terms used in such a way are interchangeable in proper circumstances, so that embodiments described herein can be implemented in other orders than the order illustrated or described herein. Moreover, terms "include", "contain" and any other variants thereof mean to cover the non-exclusive inclusion. For example, a process, a method, a system, a product, or a device that includes a list of steps or units is not necessarily limited to those expressly listed steps or units, but may include other steps or units not expressly listed or inherent to such the process, the method, the product, or the device.

It may be clearly understood by persons skilled in the art that, for the purpose of convenient and brief description, for a detailed working process of the system, the apparatus, and the unit, refer to a corresponding process in the foregoing method embodiment, and details are not described herein again.

In several embodiments provided in this application, it should be understood that the disclosed system, apparatus, and method may be implemented in another manner. For example, the described apparatus embodiment is merely an example. For example, unit division is merely logical service division and may be other division during actual implementation. For example, a plurality of units or components may be combined or integrated into another system, or some features may be ignored or not performed. In addition, the displayed or discussed mutual couplings or direct couplings or communication connections may be implemented through some interfaces. The indirect couplings or communication connections between the apparatuses or units may be implemented in electronic, mechanical, or other forms.

The units described as separate parts may or may not be physically separate, and parts displayed as units may or may not be physical units, in other words, may be located in one position, or may be distributed on a plurality of network units. Some or all of the units may be selected according to actual requirements to achieve the objectives of the solutions of embodiments.

In addition, service units in embodiments of this application may be integrated into one processing unit, or each of the units may exist alone physically, or two or more units are integrated into one unit. The integrated unit may be implemented in a form of hardware, or may be implemented in a form of a software service unit.

When the integrated unit is implemented in the form of a software service unit and sold or used as an independent product, the integrated unit may be stored in a computer-readable storage medium. Based on such an understanding, the technical solutions of this application essentially, or the part contributing to the conventional technology, or all or some of the technical solutions may be implemented in a form of a software product. The computer software product is stored in a storage medium, and includes several instructions to enable a computer device (which may be a personal computer, a server, a network device, or the like) to perform all or some of the steps of the method described in embodiments of this application. The storage medium includes any medium that can store program code, such as a USB flash drive, a removable hard disk, a read-only memory (ROM, Read-Only Memory), a random access memory (RAM, Random Access Memory), a magnetic disk, or a compact disc.

Persons skilled in the art should be aware that, in the foregoing one or more examples, the services described in the present invention may be implemented by hardware, software, firmware, or any combination thereof. When the services are implemented by the software, the services may be stored in a computer-readable medium or transmitted as one or more instructions or code in the computer-readable medium. The computer-readable medium includes a computer storage medium and a communications medium. The communications medium includes any medium that enables a computer program to be transmitted from one place to another. The storage medium may be any available medium accessible to a general-purpose or special-purpose computer.

The objectives, technical solutions, and beneficial effects of the present invention are further described in detail in the foregoing specific implementations. It should be understood that the foregoing descriptions are merely specific implementations of the present invention.

## Claims

1. A data processing method performed by a first interface (110), the method comprising:
receiving (S101), from a second interface (120), a first encoding sequence, wherein a value of a target sign bit is different from a preset value of the target sign bit in the first encoding sequence; and
parsing (S102) the first encoding sequence as if the value of the target sign bit were equal to the preset value of the target sign bit;
wherein the first encoding sequence comprises a first encoding sub-sequence, the first encoding sub-sequence comprises 2*i sign bits, wherein i is greater than or equal to 3, the first encoding sub-sequence is used to indicate logical bit information, and the target sign bit comprises any one or more of the following sign bits: the 1^{st} sign bit in the first encoding sub-sequence, the i^{th} sign bit in the first encoding sub-sequence, the (i+1)^{th} sign bit in the first encoding sub-sequence, and the (2*i)^{th} sign bit in the first encoding sub-sequence; and
**characterised in that** a preset value of the 1^{st} sign bit and a preset value of the i^{th} sign bit are determined based on a preset value of a sign bit between the 1^{st} sign bit and the i^{th} sign bit, and a preset value of the (i+1)^{th} sign bit and a preset value of the (2*i)^{th} sign bit are determined based on a preset value of a sign bit between the (i+1)^{th} sign bit andthe (2*i)^{th} sign bit.

2. The method according to claim 1, wherein the parsing (S102) the first encoding sequence as if value of the target sign bit were equal to the preset value of the target sign bit comprises:
determining the first encoding sequence as a frame marker encoding sequence of a training frame.

3. The method according to claim 1, wherein the parsing (S102) the first encoding sequence as if the value of the target sign bit were equal to the preset value of the target sign bit comprises:
encoding the first encoding sequence to obtain a second encoding sequence.

4. The method according to claim 3, wherein the first encoding sequence comprises:
a control field encoding sequence of a training frame and/or a status field encoding sequence of the training frame.

5. The method according to any one of claims 1 to 4, wherein the first encoding sequence is a non-return-to-zero encoding sequence or a four-level pulse amplitude modulation encoding sequence.

6. The method according to claim 2, wherein the target sign bit comprises m+n sign bits in the first encoding sequence and/or the last k sign bits in the first encoding sequence, wherein m is greater than or equal to 0, n is greater than or equal to 0, and k is greater than or equal to 1 and less than or equal to a second threshold, wherein
when m+n is equal to 1, the target sign bit comprises a first sign bit or a second sign bit, a preset value of the first sign bit is different from a preset value of the second sign bit, and the first sign bit is adjacent to the second sign bit; or
when m+n is greater than 1, the m+n sign bits are consecutive, preset values of the first m sign bits in the m+n sign bits are the same, preset values of the last n sign bits in the m+n sign bits are the same, and the preset values of the first m sign bits are different from the preset values of the last n sign bits.

7. The method according to claim 6, wherein m is equal to n.

8. The method according to claim 1, wherein if the first encoding sequence is a four-level pulse amplitude modulation encoding sequence, the target sign bit further comprises a first sign bit sequence or a second sign bit sequence, wherein the first sign bit sequence comprises the 2^{nd} sign bit to the (i-1)^{th} sign bit in the first encoding sub-sequence, and the second sign bit sequence comprises the (i+1)^{th} sign bit to the (2*i-1)^{th} sign bit in the first encoding sub-sequence.

9. The method according to claim 8, wherein a preset value of each sign bit in the first sign bit sequence is determined in the following manner:
if a value of each sign bit in the first sign bit sequence is 0 or 1, determining that the preset value of each sign bit in the first sign bit sequence is 0; or if a value of each sign bit in the first sign bit sequence is 2 or 3, determining that the preset value of each sign bit in the first sign bit sequence is 3; and
a preset value of each sign bit in the second sign bit sequence is determined in the following manner:
if a value of each sign bit in the second sign bit sequence is 0 or 1, determining that the preset value of each sign bit in the second sign bit sequence is 0; or if a value of each sign bit in the second sign bit sequence is 2 or 3, determining that the preset value of each sign bit in the second sign bit sequence is 3.

10. The method according to claim 2 or 5, wherein when the first encoding sequence is a four-level pulse amplitude modulation encoding sequence, the target sign bit comprises the first p sign bits in the first encoding sequence, wherein p is greater than or equal to 1 and less than or equal to a first threshold.

11. The method according to any one of claims 5 to 10, wherein when the first encoding sequence is a four-level pulse amplitude modulation encoding sequence, the parsing (S102), if a value of a target sign bit is different from a preset value of the target sign bit in the first encoding sequence, the first encoding sequence as if the value of the target sign bit were equal to the preset value of the target sign bit comprises:
if a difference between the value of the target sign bit and the preset value of the target sign bit is equal to 1, parsing the first encoding sequence as if the value of the target sign bit were equal to the preset value of the target sign bit.

12. The method according to any one of claims 2, 4 or of claims 5-7 and 10-11 when dependent on claim 2 or 4, wherein the training frame is encoded through four-level pulse amplitude modulation, PAM4.

13. A device, comprising a processor and a memory, wherein
the memory is configured to store instructions or a computer program; and
the processor is configured to execute the instructions or the computer program, to perform the method according to any one of claims 1 to 12.

14. A computer-readable storage medium, including instructions or a computer program, when the computer program runs on a computer, the computer is enabled to perform the method according to any one of claims 1 to 12.

## Patentansprüche

1. Datenverarbeitungsverfahren, das von einer ersten Schnittstelle (110) durchgeführt wird, wobei das Verfahren Folgendes umfasst:
Empfangen (S101) einer ersten Codierungssequenz von einer zweiten Schnittstelle (120), wobei sich ein Wert eines Zielvorzeichenbits von einem voreingestellten Wert des Zielvorzeichenbits in der ersten Codierungssequenz unterscheidet; und
Parsen (S102) der ersten Codierungssequenz, als ob der Wert des Zielvorzeichenbits gleich dem voreingestellten Wert des Zielvorzeichenbits wäre;
wobei die erste Codierungssequenz eine erste Codierungsteilsequenz umfasst, die erste Codierungsteilsequenz 2 * i Vorzeichenbits umfasst, wobei i größer oder gleich 3 ist, die erste Codierungsteilsequenz verwendet wird, um logische Bitinformationen anzuzeigen, und das Zielvorzeichenbit eines oder mehrere der folgenden Vorzeichenbits umfasst: das 1. Vorzeichenbit in der ersten Codierungsteilsequenz, das i-te Vorzeichenbit in der ersten Codierungsteilsequenz, das (i + 1)-te Vorzeichenbit in der ersten Codierungsteilsequenz und das (2 * i)-te Vorzeichenbit in der ersten Codierungsteilsequenz; und
**dadurch gekennzeichnet, dass** ein voreingestellter Wert des 1. Vorzeichenbits und ein voreingestellter Wert des i-ten Vorzeichenbits basierend auf einem voreingestellten Wert eines Vorzeichenbits zwischen dem 1. Vorzeichenbit und dem i-ten Vorzeichenbit bestimmt werden und ein voreingestellter Wert des (i + 1)-ten Vorzeichenbits und ein voreingestellter Wert des (2 * i)-ten Vorzeichenbits basierend auf einem voreingestellten Wert eines Vorzeichenbits zwischen dem (i + 1)-ten Vorzeichenbit und dem (2 * i)-ten Vorzeichenbit bestimmt werden.

2. Verfahren nach Anspruch 1, wobei das Parsen (S102) der ersten Codierungssequenz, als ob der Wert des Zielvorzeichenbits gleich dem voreingestellten Wert des Zielvorzeichenbits wäre, Folgendes umfasst:
Bestimmen der ersten Codierungssequenz als eine Rahmenmarkierungs-Codierungssequenz eines Trainingsrahmens.

3. Verfahren nach Anspruch 1, wobei das Parsen (S102) der ersten Codierungssequenz, als ob der Wert des Zielvorzeichenbits gleich dem voreingestellten Wert des Zielvorzeichenbits wäre, Folgendes umfasst:
Codieren der ersten Codierungssequenz, um eine zweite Codierungssequenz zu erhalten.

4. Verfahren nach Anspruch 3, wobei die erste Codierungssequenz Folgendes umfasst: eine Steuerfeld-Codierungssequenz eines Trainingsrahmens und/oder eine Statusfeld-Codierungssequenz des Trainingsrahmens.

5. Verfahren nach einem der Ansprüche 1 bis 4, wobei die erste Codierungssequenz eine Non-Return-to-Zero-Codierungssequenz oder eine Codierungssequenz mit vierstufiger Pulsamplitudenmodulation ist.

6. Verfahren nach Anspruch 2, wobei das Zielvorzeichenbit m + n Vorzeichenbits in der ersten Codierungssequenz und/oder die letzten k Vorzeichenbits in der ersten Codierungssequenz umfasst, wobei m größer oder gleich 0 ist, n größer oder gleich 0 ist und k größer oder gleich 1 und kleiner als ein zweiter Schwellenwert oder gleich diesem ist, wobei,
wenn m + n gleich 1 ist, das Zielvorzeichenbit ein erstes Vorzeichenbit oder ein zweites Vorzeichenbit umfasst, ein voreingestellter Wert des ersten Vorzeichenbits sich von einem voreingestellten Wert des zweiten Vorzeichenbits unterscheidet und das erste Vorzeichenbit benachbart zum zweiten Vorzeichenbit ist; oder
wenn m + n größer als 1 ist, die m + n Vorzeichenbits aufeinanderfolgend sind, voreingestellte Werte der ersten m Vorzeichenbits in den m + n Vorzeichenbits gleich sind, voreingestellte Werte der letzten n Vorzeichenbits in den m + n Vorzeichenbits gleich sind und die voreingestellten Werte der ersten m Vorzeichenbits sich von den voreingestellten Werten der letzten n Vorzeichenbits unterscheiden.

7. Verfahren nach Anspruch 6, wobei m gleich n ist.

8. Verfahren nach Anspruch 1, wobei, wenn die erste Codierungssequenz eine Codierungssequenz mit vierstufiger Pulsamplitudenmodulation ist, das Zielvorzeichenbit ferner eine erste Vorzeichenbitsequenz oder eine zweite Vorzeichenbitsequenz umfasst, wobei die erste Vorzeichenbitsequenz das 2. Vorzeichenbit bis zum (i - 1)-ten Vorzeichenbit in der ersten Codierungsteilsequenz umfasst und die zweite Vorzeichenbitsequenz das (i + 1)-te Vorzeichenbit bis zum (2 * i - 1)-ten Vorzeichenbit in der ersten Codierungsteilsequenz umfasst.

9. Verfahren nach Anspruch 8, wobei ein voreingestellter Wert jedes Vorzeichenbits in der ersten Vorzeichenbitsequenz auf die folgende Art und Weise bestimmt wird:
wenn ein Wert jedes Vorzeichenbits in der ersten Vorzeichenbitsequenz 0 oder 1 ist, Bestimmen, dass der voreingestellte Wert jedes Vorzeichenbits in der ersten Vorzeichenbitsequenz 0 ist; oder, wenn ein Wert jedes Vorzeichenbits in der ersten Vorzeichenbitsequenz 2 oder 3 ist, Bestimmen, dass der voreingestellte Wert jedes Vorzeichenbits in der ersten Vorzeichenbitsequenz 3 ist; und
wobei ein voreingestellter Wert jedes Vorzeichenbits in der zweiten Vorzeichenbitsequenz auf die folgende Art und Weise bestimmt wird:
wenn ein Wert jedes Vorzeichenbits in der zweiten Vorzeichenbitsequenz 0 oder 1 ist, Bestimmen, dass der voreingestellte Wert jedes Vorzeichenbits in der zweiten Vorzeichenbitsequenz 0 ist; oder, wenn ein Wert jedes Vorzeichenbits in der zweiten Vorzeichenbitsequenz 2 oder 3 ist, Bestimmen, dass der voreingestellte Wert jedes Vorzeichenbits in der zweiten Vorzeichenbitsequenz 3 ist.

10. Verfahren nach Anspruch 2 oder 5, wobei, wenn die erste Codierungssequenz eine Codierungssequenz mit vierstufiger Pulsamplitudenmodulation ist, das Zielvorzeichenbit die ersten p Vorzeichenbits in der ersten Codierungssequenz umfasst, wobei p größer oder gleich 1 und kleiner oder gleich einem ersten Schwellenwert ist.

11. Verfahren nach einem der Ansprüche 5 bis 10, wobei, wenn die erste Codierungssequenz eine Codierungssequenz mit vierstufiger Pulsamplitudenmodulation ist, das Parsen (S102) der ersten Codierungssequenz, als ob der Wert des Zielvorzeichenbits gleich dem voreingestellten Wert des Zielvorzeichenwerts wäre, Folgendes umfasst, wenn sich ein Wert eines Zielvorzeichenbits von einem voreingestellten Wert des Zielvorzeichenbits in der ersten Codierungssequenz unterscheidet:
wenn eine Differenz zwischen dem Wert des Zielvorzeichenbits und dem voreingestellten Wert des Zielvorzeichenbits gleich 1 ist, Parsen der ersten Codierungssequenz, als ob der Wert des Zielvorzeichenbits gleich dem voreingestellten Wert des Zielvorzeichenbits wäre.

12. Verfahren nach einem der Ansprüche 2, 4 oder 5-7 und 10-11, wenn abhängig von Anspruch 2 oder 4, wobei der Trainingsrahmen durch vierstufige Pulsamplitudenmodulation, PAM4, codiert wird.

13. Vorrichtung, umfassend einen Prozessor und einen Speicher, wobei der Speicher zum Speichern von Anweisungen oder eines Computerprogramms ausgelegt ist, und
der Prozessor so ausgelegt ist, dass er die Anweisungen oder das Computerprogramm ausführt, um das Verfahren nach einem der Ansprüche 1 bis 12 durchzuführen.

14. Computerlesbares Speichermedium, umfassend Anweisungen oder ein Computerprogramm, wobei, wenn das Computerprogramm auf einem Computer ausgeführt wird, der Computer zum Durchführen des Verfahrens nach einem der Ansprüche 1 bis 12 in der Lage ist.

## Revendications

1. Procédé de traitement de données effectué par une première interface (110), le procédé comprenant :
la réception (S101), d'une deuxième interface (120), d'une première séquence de codage, une valeur d'un bit de signe cible étant différente d'une valeur prédéfinie du bit de signe cible dans la première séquence de codage ; et
l'analyse (S102) de la première séquence de codage comme si la valeur du bit de signe cible était égale à la valeur prédéfinie du bit de signe cible ;
dans lequel la première séquence de codage comprend une première sous-séquence de codage, la première sous-séquence de codage comprend 2*i bits de signe, où i est supérieur ou égal à 3, la première sous-séquence de codage est utilisée pour indiquer une information binaire logique, et le bit de signe cible comprend un quelconque ou plusieurs des bits de signe suivants : le 1^{er} bit de signe dans la première sous-séquence de codage, le i^{ième} bit de signe dans la première sous-séquence de codage, le (i+1)^{ième} bit de signe dans la première sous-séquence de codage, et le (2*i)^{ième} bit de signe dans la première sous-séquence de codage ; et
**caractérisé en ce qu'**une valeur prédéfinie du 1^{er} bit de signe et qu'une valeur prédéfinie du i^{ième} bit de signe sont déterminées sur la base d'une valeur prédéfinie d'un bit de signe situé entre le 1^{er} bit de signe et le i^{ième} bit de signe, et qu'une valeur prédéfinie du (i+1)^{ième} bit de signe et qu'une valeur prédéfinie du (2*i)^{ième} bit de signe sont déterminées sur la base d'une valeur prédéfinie d'un bit de signe situé entre le (i+1)^{ième} bit de signe et le (2*i)^{ième} bit de signe.

2. Procédé selon la revendication 1, dans lequel l'analyse (S102) de la première séquence de codage comme si la valeur du bit de signe cible était égale à la valeur prédéfinie du bit de signe cible comprend :
la détermination de la première séquence de codage en tant que séquence de codage de marqueur de trame d'une trame d'entraînement.

3. Procédé selon la revendication 1, dans lequel l'analyse (S102) de la première séquence de codage comme si la valeur du bit de signe cible était égale à la valeur prédéfinie du bit de signe cible comprend :
le codage de la première séquence de codage pour obtenir une deuxième séquence de codage.

4. Procédé selon la revendication 3, dans lequel la première séquence de codage comprend :
une séquence de codage de champ de commande d'une trame d'entraînement et/ou une séquence de codage de champ de statut de la trame d'entraînement.

5. Procédé selon l'une quelconque des revendications 1 à 4, dans lequel la première séquence de codage est une séquence de codage sans retour à zéro ou une séquence de codage de modulation d'amplitude d'impulsion à quatre niveaux.

6. Procédé selon la revendication 2, dans lequel le bit de signe cible comprend m+n bits de signe dans la première séquence de codage et/ou les k derniers bits de signe dans la première séquence de codage, où m est supérieur ou égal à 0, n est supérieur ou égal à 0, et k est supérieur ou égal à 1 et inférieur ou égal à un deuxième seuil, dans lequel
lorsque m+n est égal à 1, le bit de signe cible comprend un premier bit de signe ou un deuxième bit de signe, une valeur prédéfinie du premier bit de signe est différente d'une valeur prédéfinie du deuxième bit de signe, et le premier bit de signe est adjacent au deuxième bit de signe ; ou
lorsque m+n est supérieur à 1, les m+n bits de signe sont consécutifs, les valeurs prédéfinies des m premiers bits de signe parmi les m+n bits de signe sont identiques, les valeurs prédéfinies des n derniers bits de signe parmi les m+n bits de signe sont identiques, et les valeurs prédéfinies des m premiers bits de signe sont différentes des valeurs prédéfinies des n derniers bits de signe.

7. Procédé selon la revendication 6, dans lequel m est égal à n.

8. Procédé selon la revendication 1, dans lequel, si la première séquence de codage est une séquence de codage de modulation d'amplitude d'impulsion à quatre niveaux, le bit de signe cible comprend également une première séquence de bits de signe ou une deuxième séquence de bits de signe, la première séquence de bits de signe comprenant du 2^{ème} bit de signe au (i-1)^{ième} bit de signe dans la première sous-séquence de codage, et la deuxième séquence de bits de signe comprenant du (i+1)^{ième} bit de signe au (2*i-1)^{ième} bit de signe dans la première sous-séquence de codage.

9. Procédé selon la revendication 8, dans lequel une valeur prédéfinie de chaque bit de signe dans la première séquence de bits de signe est déterminée de la manière suivante :
si une valeur de chaque bit de signe dans la première séquence de bits de signe est 0 ou 1, déterminer que la valeur prédéfinie de chaque bit de signe dans la première séquence de bits de signe est 0 ; ou si une valeur de chaque bit de signe dans la première séquence de bits de signe est 2 ou 3, déterminer que la valeur prédéfinie de chaque bit de signe dans la première séquence de bits de signe est 3 ; et
une valeur prédéfinie de chaque bit de signe dans la deuxième séquence de bits de signe est déterminée de la manière suivante :
si une valeur de chaque bit de signe dans la deuxième séquence de bits de signe est 0 ou 1, déterminer que la valeur prédéfinie de chaque bit de signe dans la deuxième séquence de bits de signe est 0 ; ou si une valeur de chaque bit de signe dans la deuxième séquence de bits de signe est 2 ou 3, déterminer que la valeur prédéfinie de chaque bit de signe dans la deuxième séquence de bits de signe est 3.

10. Procédé selon la revendication 2 ou 5, dans lequel, lorsque la première séquence de codage est une séquence de codage de modulation d'amplitude d'impulsion à quatre niveaux, le bit de signe cible comprend les p premiers bits de signe dans la première séquence de codage, où p est supérieur ou égal à 1 et inférieur ou égal à un premier seuil.

11. Procédé selon l'une quelconque des revendications 5 à 10, dans lequel, lorsque la première séquence de codage est une séquence de codage de modulation d'amplitude d'impulsion à quatre niveaux, l'analyse (S102), si une valeur d'un bit de signe cible est différente d'une valeur prédéfinie du bit de signe cible dans la première séquence de codage, de la première séquence de codage comme si la valeur du bit de signe cible était égale à la valeur prédéfinie du bit de signe cible comprend :
si une différence entre la valeur du bit de signe cible et la valeur prédéfinie du bit de signe cible est égale à 1, l'analyse de la première séquence de codage comme si la valeur du bit de signe cible était égale à la valeur prédéfinie du bit de signe cible.

12. Procédé selon l'une quelconque des revendications 2, 4, ou des revendications 5 à 7 et 10 et 11 lorsqu'elles dépendent de la revendication 2 ou 4, dans lequel la trame d'entraînement est codée par une modulation d'amplitude d'impulsion à quatre niveaux, PAM4.

13. Dispositif, comprenant un processeur et une mémoire, dans lequel
la mémoire est configurée pour stocker des instructions ou un programme informatique ; et
le processeur est configuré pour exécuter les instructions ou le programme informatique, pour réaliser le procédé selon l'une quelconque des revendications 1 à 12.

14. Support de stockage lisible par ordinateur, contenant des instructions ou un programme informatique, lorsque le programme informatique s'exécute sur un ordinateur, l'ordinateur est activé pour réaliser le procédé selon l'une quelconque des revendications 1 à 12.
